Europäisches Patentamt

European Patent Office

Office européen des brevets

(19)

(11) Publication number: 0 278 065 A2

(12) EUROPEAN PATENT APPLICATION

(21) Application number: 87116426.5

(51) Int. Cl.⁴: H01L 27/08

(22) Date of filing: 06.11.87

(30) Priority: 10.02.87 JP 27253/87

(43) Date of publication of application:
17.08.88 Bulletin 88/33

(84) Designated Contracting States:
DE FR GB

(71) Applicant: KABUSHIKI KAISHA TOSHIBA
72, Horikawa-cho Saiwai-ku
Kawasaki-shi Kanagawa-ken 210(JP)

(72) Inventor: Morimoto, Toshiki c/o Patent
Division K.K. Toshiba
1-1 Shibaura 1-chome
Minato-ku Tokyo 105(JP)
Inventor: Watanabe, Seiji c/o Patent Division
K.K. Toshiba
1-1 Shibaura 1-chome
Minato-ku Tokyo 105(JP)
Inventor: Tanaka, Yutaka c/o Patent Division
K.K. Toshiba
1-1 Shibaura 1-chome
Minato-ku Tokyo 105(JP)

(74) Representative: Lehn, Werner, Dipl.-Ing. et al
Hoffmann, Eitle & Partner Patentanwälte
Arabellastrasse 4
D-8000 München 81(DE)

(54) Semiconductor integrated circuit latch-up preventing apparatus.

(57) This invention discloses a semiconductor integrated circuit latch-up preventing apparatus. Impurity diffusion regions (9) are formed along uppermost and lowermost cell arrays (11-1, 11-n) in an internal element region (2), and power supply lines (12) are formed on the impurity diffusion regions (9).

F I G. 3

## Semiconductor integrated circuit latch-up preventing apparatus

The present invention relates to a semiconductor integrated circuit latch-up preventing apparatus, in a standard cell type CMOS semi-custom LSI, formed in a wiring region between an internal element region of a chip region and an external input/output buffer region thereof.

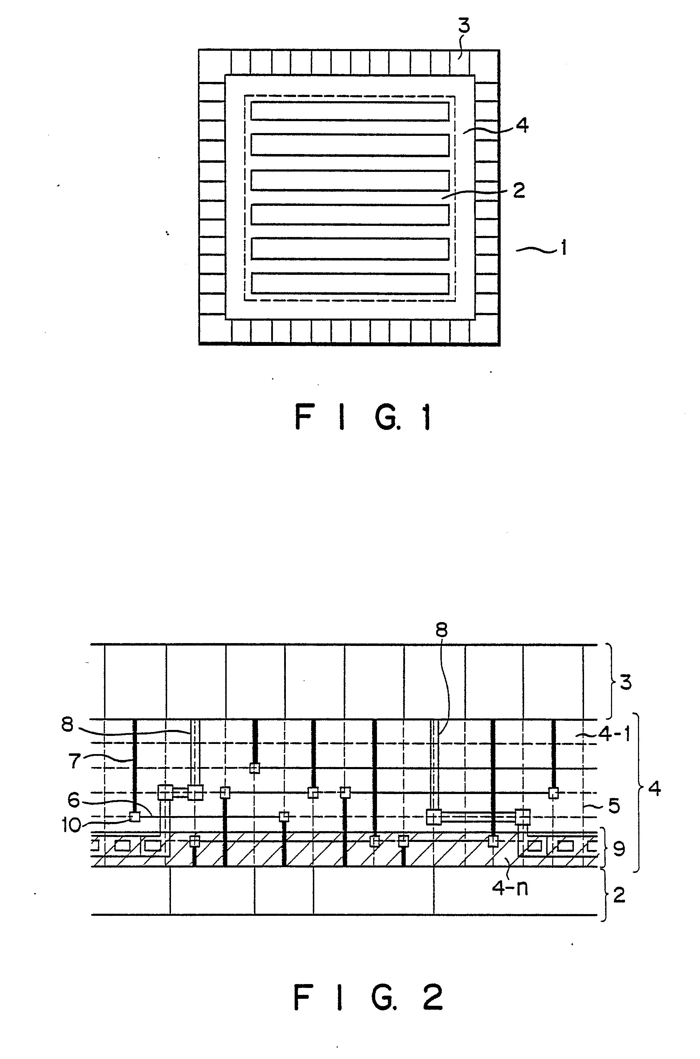

In a conventional standard cell type CMOS semi-custom LSI, internal element region 2 of chip region 1 and external input/output buffer region 3 of chip region 1 are electrically connected to each other as shown in Figs. 1 and 2 in the following manner. In wiring region 4 between internal element region 2 of chip region 1 and external input/output buffer region 3 thereof, basic mesh 5 is automatically or manually wire-drawn in the longitudinal and transverse directions indicated by the broken lines as shown in Fig. 2. Aluminum wirings 6 and 7 of first and second layers are respectively formed along the transverse and longitudinal directions of basic mesh 5. Aluminum wirings 6 and 7 of the first and second layers are connected by wiring contacts 10. As a result, internal element region 2 and external input/output buffer region 3 are electrically connected. Note that wiring region 4 is constituted by wiring region units 4-1, 4-2,..., 4-n formed by wire drawing of basic meshes 5a and 5b.

In the above-described wiring layout of the standard cell type CMOS semi-custom LSI, after aluminum wirings 6 and 7 of the first and second layers are formed in wiring region 4 as shown in Fig. 2, a portion in which aluminum wirings 6 and 7 of the first and second layers are not formed is selected from wiring region 4, and power supply wirings 8 are formed in the portion. Impurity diffusion region 9 for preventing latch-up, which is formed along a periphery of internal element region 2, and power supply wirings 8 are connected to each other through contacts and constitute a cut-well structure. Power supply wirings 8 are formed by selecting either aluminum wirings 6 of the first layer or wirings 7 of the second layer and increasing the thickness thereof.

The order of wiring connections in the wiring layout of the conventional standard cell type CMOS semi-custom LSI is as follows. Aluminum wirings 6 and 7 of first and second layers are formed. Then, power supply wirings 8 for preventing latch-up are formed in parallel with aluminum wirings 6 and 7 of the first and second layers in wiring region 4 at a position where aluminum wirings 6 and 7 of the first and second layers are not formed.

Accordingly, such a wiring operation is cumbersome if it is performed manually. If signal wirings are locally concentrated on impurity diffusion region 9 formed along the periphery of internal element region 2 for preventing latch-up, power supply wirings 8 cannot be formed in the concentrated region. As a result, contact of impurity diffusion region 9 for preventing latch-up with power supply wirings 8 is limited to a specific region, resulting in degradation of the effect of latch-up prevention.

It is an object of the present invention to provide a semiconductor integrated circuit latch-up preventing apparatus which can eliminate a drawback, i.e., that contact connection of an impurity diffusion region for preventing latch-up and a power supply line cannot be performed in a region where signal lines are concentrated, resulting in a loss of latch-up effect, and which allows easy wire forming when wiring is automatically formed.

The present invention is characterized in that a wiring region constituted by a plurality of wiring region units formed by wire drawing of a basic mesh is formed between an internal element region and an external input/output buffer region, impurity diffusion regions for preventing latch-up are respectively formed along upper and lower sides of the internal element region, power supply lines connected to the external input/output buffer region are formed on the impurity diffusion regions, and the power supply lines and the impurity diffusion regions are connected by contacts.

According to the present invention, a power line forming region is arranged in a wiring region formed between an internal element region and an external input/output buffer region, then power supply lines which electrically connect the internal element region and the external input/output buffer region are linearly formed in the arranged power line forming regions. Subsequently, the entire region of the impurity diffusion regions for preventing latch-up and the power supply lines are connected by contacts, thereby improving the latch-up effect between the internal element region and the external input/output buffer region.

This invention can be more fully understood from the following detailed description when taken in conjunction with the accompanying drawings, in which:

Fig. 1 is a plan view of a chip region having a conventional semiconductor integrated circuit latch-up preventing apparatus;

Fig. 2 is a partially enlarged plan view of the conventional semiconductor integrated circuit latch-up preventing apparatus;

Fig. 3 is a plan view of a chip region having a semiconductor integrated circuit latch-up preventing apparatus according to the present invention; and

Fig. 4 is a partially enlarged plan view of the semiconductor integrated circuit latch-up preventing apparatus according to the present invention.

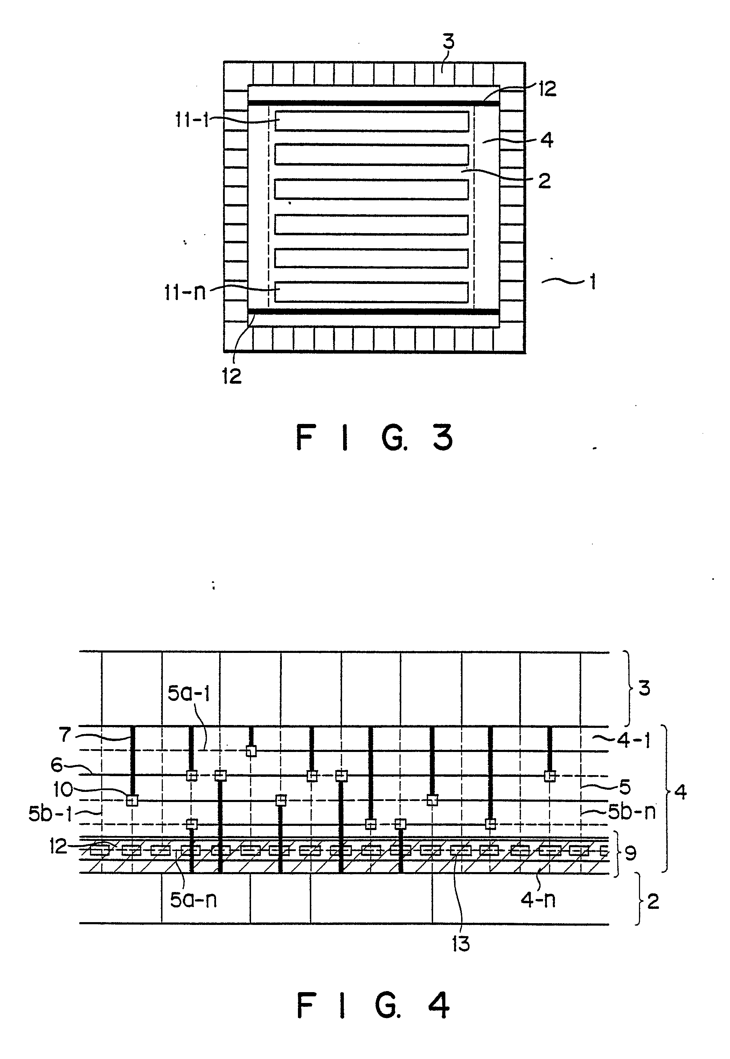

An embodiment of the present invention will be described with reference to the accompanying drawings. Referring to Fig. 3, reference numeral 1 denotes a chip region, wherein internal element region 2 and external input/output buffer region 3 are formed. Wiring region 4 is formed between internal element region 2 and external input/output buffer region 3. In wiring region 4, a pair of power supply lines 12 are formed in parallel with uppermost and lowermost cell arrays 11-1 and 11-n of cell arrays 11-1, 11-2,..., 11-n formed in internal element region 2.

Fig. 4 is a partially enlarged plan view of wiring region 4 in chip region 1 shown in Fig. 3. Wiring region 4 is constituted by wiring region units 4-1, 4-2,..., 4-n formed by wire-drawn by basic meshes 5a-1, 5a-2,..., 5a-n formed in the transverse direction. Impurity diffusion region 9 is formed along uppermost cell array 11-1 of internal element region 2 within wiring region 4. Impurity diffusion region 9 has $p^+$-or $n+$-type diffusion layers, and is simultaneously formed when a transistor is formed outside the cell arrays. Wiring of signal lines in wiring region 4 is formed in the following manner. Aluminum wirings 6 of a first layer are formed on and along several basic meshes selected from basic meshes 5a-1, 5a-2,...5a-n, and at the same time power supply lines 12 are formed. Power supply lines 12 need be formed on impurity diffusion region 9. Contacts 10 and 13 are formed to electrically connect power supply lines 12 and impurity diffusion regions 9. Then, aluminum (or silicon) wirings 7 are formed on basic meshes selected from basic meshes 5b-1, 5b-2,..., 5b-n formed in the longitudinal direction. Wirings 6 and 7 of the first and second layers are connected by contacts 10, thereby connecting internal element region 2 and external input/output buffer region 3.

Note that impurity diffusion region 9 and power supply line 12 are also formed along lowermost array 11-n in internal element region 2.

Impurity diffusion regions 9 are formed along uppermost and lowermost cell arrays 11-1 and 11-n in internal element region 2, power supply lines 12 are respectively formed on impurity diffusion regions 9, and impurity diffusion regions 9 and power supply lines 12 are connected by the contacts so that internal element 2 is isolated from external input/output buffer region 3 by the cut-well structure and internal element region 2 is connected to power supply lines 12. As a result, a current flowing through a semiconductor substrate can be controlled, and hence a latch-up phenomenon cannot easily occur.

Since power supply lines 12 are formed on impurity diffusion regions 9, contacts 13 of impurity diffusion regions 9 and power supply lines 12 can be formed at any given portion on supply lines 12. Therefore, the latch-up effect is improved.

## Claims

1. A semiconductor integrated circuit latch-up preventing apparatus wherein an internal element region and an external input/output buffer region are formed in a chip region, a wiring region is formed between said internal element region and said external input/output buffer region, impurity diffusion regions for preventing latch-up are formed in said wiring region, and said impurity diffusion regions and said external input/output buffer region are electrically connected by power supply lines, characterized in that
said impurity diffusion regions are formed near/along said internal element region in said wiring region, said power supply lines are formed on said impurity diffusion regions, and said power supply lines and said impurity diffusion region are electrically connected by contacts.

2. An apparatus according to claim 1, characterized in that said wiring region is constituted by a plurality of wiring region units formed by wire drawing of basic meshes.

3. An apparatus according to claim 1, characterized in that said internal element region includes a plurality of cell arrays.

4. An apparatus according to claim 1, characterized in that said wiring region is constituted by a plurality of wiring region units formed by wire drawing of said basic meshes, and said internal element region includes a plurality of cell arrays.

5. An apparatus according to claim 4, characterized in that said power supply lines are formed along uppermost and lowermost cell arrays of said internal element region in an appropriate number of said wiring region units of said wiring region.

6. An apparatus according to claim 1, characterized in that said wiring of the first layer is formed by aluminum.

7. An apparatus according to claim 1, characterized in that said wiring of the second layer is formed by aluminum.

8. An apparatus according to claim 1, characterized in that said wiring of the second layer is formed by polysilicon.

F I G. 1

F I G. 2

F I G. 3

F I G. 4